# EUROPÄISCHE PATENTSCHRIFT

(11) **EP 2 613 347 B1**
(45) Veröffentlichungstag und Bekanntmachung des Hinweises auf die Patenterteilung: **21.06.2023**
(21) Anmeldenummer: 12199389.3
(22) Anmeldetag: 27.12.2012
(51) Int. Cl.: H01L 21/683, H01L 21/687, H01L 21/67, D21F 1/36, D21G 1/00, D21G 1/02

(54) **Substratteller**
Substrate plate
Plaque de substrat

(30) Priorität: 03.01.2012 DE 102012100030
(43) Veröffentlichungstag der Anmeldung: 10.07.2013
(73) Patentinhaber: Solar-Semi GmbH, 78315 Radolfzell (DE)
(72) Erfinder: Muffler, Pirmin, 78359 Orsingen-Nenzingen (DE)
(74) Vertreter: Patentanwälte und Rechtsanwalt Weiß, Arat & Partner mbB

(56) Entgegenhaltungen:
- EP-A1- 0 456 426
- EP-A2- 0 053 278
- WO-A1-99/30840
- WO-A2-2005/103825
- US-A1- 2002 094 260
- US-A1- 2009 277 379
- US-B1- 6 196 532

## Beschreibung

### TECHNISCHES GEBIET

Die Erfindung betrifft einen Substratsteller nach dem Oberbegriff des Anspruchs 1.

### STAND DER TECHNIK

Zum Bearbeiten, insbesondere zum Belacken und/oder Beschichten von Substraten werden meist Vorrichtungen, die einen Drehteller und einen Substratsteller aufweisen, eingesetzt. Unterhalb des Drehtellers ist ein Antrieb angeordnet, welcher über eine Rotationswelle den Drehteller und auch den Substratteller rotierend bewegt.

Dabei wird auf die EP 0 053 278 A2 hingewiesen. Es handelt sich um die Unterdruck-Haltevorrichtung für flache Werkstücke, wobei das Auflageelement eine konvexe Oberfläche aufweist. Auch in der WO 99(30840 A1 wird eine Vorrichtung zum Drehbelacken des Substrats offenbart, bei dem sich der Substratteller mit dem Substrat drehen und der Innenbereich atmosphärisch abgeschlossen ist. Weiter wird auf die US 2009/0277379 A1 hingewiesen, welche zum Belacken von Substraten genutzt wird, wobei durch den Einsatz des Bernoulli-Effektes eine möglichst gleichmäßige Verteilung des Lackes auf dem Substrat erreicht wird. Ausserdem wird auf die EP 0 456 426 A1 verwiesen, welche einen Substrathalter offenbart, bei dem eine Vakuumquelle mit Vakuumauslässen das Substrat auf die Auflagefläche zieht. Weiter wird auf die US 6,196,523 B1 hingewiesen. Dort ist eine Vorrichtung zum Belacken von Substraten offenbart, welche spezielle Ansaugventile aufweist.

Daneben wird auf die US 2002/0094260 A1 verwiesen, welche eine Vorrichtung zum Bearbeiten von Halbleitersubstraten offenbart.

Ausserdem wird auf die WO 2005/103825 A2 hingewiesen, welche eine Vorrichtung zum Drehbelacken von Substraten darstellt.

Beispielsweise offenbart die EP 1 743 220 B1 eine solche Vorrichtung. Allerdings ist in dieser nicht offenbart, wie das Substrat auf dem Substratteller gehalten wir.

Die bekannten Haltemethoden haben den Nachteil, dass sie eine bereits belackte und/oder beschichtete Oberfläche eines Substrats beschädigen können. Dies ist besonders nachteilig bei Substraten, die beidseitig belackt und/oder beschichtet werden sollen. Des Weiteren ist nachteilig, dass die nach unten gerichtete Substratfläche, die in einem späteren Arbeitsgang noch belackt und/oder beschichtet werden soll, bereits beim Belacken und/oder Beschichten der anderen Seite Spritzer abbekommen kann.

### BESCHREIBUNG DER ERFINDUNG

Aufgabe der Erfindung ist, einen Substratteller bereit zu stellen, der die oben genannten Nachteile minimiert oder sogar behebt und dabei die Unterseite der zu belackenden Substratfläche möglichst einwandfrei erhalten bleibt.

Zur Lösung der Aufgabe führen die Merkmale des Anspruchs 1.

In erfindungsgemäßen Ausführungsbeispielen umfasst ein Substratsteller zur Aufnahme eines Substrats an seiner Oberfläche einen Ansaugpunkt. Dadurch ergibt sich der Vorteil, dass das Substrat über den Ansaugpunkt angesaugt wird und dadurch sicher auf dem Substratsteller gehalten werden kann. Auch beim Drehen, Beschleunigen und Abbremsen des Substratstellers besteht nicht die Gefahr, dass das Substrat herunter fällt. Dadurch, dass die Haltekraft über einen Ansaugpunkt ausgeübt wird, ergibt sich der Vorteil, dass eine Beschädigungsgefahr durch Halteelemente, Greifer, Klammern oder dergleichen zumindest minimiert wird.

In erfindungsgemäßen Ausführungsbeispielen umfasst der Ansaugpunkt einen Abstand von einer Oberfläche des Substratstellers. Dadurch ergibt sich der Vorteil, dass der Substratsteller nur mit dem Ansaugpunkt in Berührung kommt, wodurch sich nur wenige Kontaktflächen, die zu Beschädigungen führen könnten, ergeben.

Erfindungsgemäß weist der Ansaugpunkt einen Abstand von 1 mm bis 30 mm, besonders bevorzugt 7 mm von einer Oberfläche des Substratstellers auf. Dadurch ergibt sich der Vorteil, dass ein ausreichender Abstand erreicht, wird, aber ein den Ansaugpunkt ausbildendes Röhrchen noch eine ausreichende Stabilität aufweist.

In erfindungsgemäßen Ausführungsbeispielen umfasst der Substratsteller eine Mehrzahl von Ansaugpunkten. Dadurch ergibt sich der Vorteil, dass der Substratsteller sicher in einer Ebene gehalten wird und nicht kippen kann. Desweiteren ist vorteilhaft, dass durch die Mehrzahl der Ansaugpunkte an jedem einzelnen des Ansaugpunkts nur eine geringere Haltekraft benötigt wird. Deshalb reicht es aus, wenn nur ein geringer Unterdruck an den Substratsteller, bzw. den Ansaugpunkten angelegt wird.

In typischen Ausführungsbeispielen umfasst der Substratsteller drei, vier oder fünf Ansaugpunkte. Dies ist besonders vorteilhaft, weil dadurch der Substratsteller sicher gehalten wird und keine langen Leitungen entstehen.

In erfindungsgemäßen Ausführungsbeispielen ist der Ansaugpunkt über einen Kanal mit einer Unterdruckquelle verbunden. Dadurch ergibt sich der Vorteil, dass an die Ansaugpunkte ein Unterdruck angelegt werden kann, wodurch sich die Haltekraft ergibt.

In erfindungsgemäßen Ausführungsbeispielen sind die Kanäle in dem Substratsteller angeordnet. Bevorzugt sind die Kanäle in einer Platte des Substratstellers angeordnet. Dadurch ergibt sich der Vorteil, dass keine zusätzlichen Leitungen oder Schläuche gelegt werden müssen. Dies ist besonders vorteilhaft, da der Substratsteller ja mit hoher Geschwindigkeit gedreht wird.

In erfindungsgemäßen Ausführungsbeispielen ist der Kanal in eine Oberfläche des Substratstellers beziehungsweise in eine Platte des Substratstellers eingefräst. Dadurch ergibt sich der Vorteil, dass der Kanal beziehungsweise die Kanäle auf sehr einfache Art und Weise herstellbar sind.

In erfindungsgemäßen Ausführungsbeispielen wird in die eingesetzte Vertiefung jeweils ein Verschlussstück eingesetzt, um den Kanal abzuschließen. Auf diese Weise bleibt ein Kanal frei. Dies ist besonders vorteilhaft, weil dadurch die Herstellung des Kanals sehr vereinfacht wird und kein Bohren von langen Löchern notwendig ist.

In erfindungsgemäßen Ausführungsbeispielen umfasst der Ansaugpunkt eine flexible Oberfläche. Dadurch ergibt sich der Vorteil, dass der Ansaugpunkt an den Stellen, die mit dem Substrat in Kontakt kommen, keine harten Kanten aufweist, die zu einer Beschädigung des Substrats führen könnten. Vorzugsweise umfasst der Ansaugpunkt eine Gummilippe, die die flexible Oberfläche ausbildet.

Gesondert wird auf die Verwendung eines Substratstellers in einer Vorrichtung zum Drehbelacken von Substraten hingewiesen. Dadurch ergibt sich der Vorteil, dass das Substrat in einer Vorrichtung zum Drehbelacken und/oder Beschichten sicher gehalten werden können. Zudem wird das Substrat durch die Ausbildung der Ansaugpunkte rückseitenschonend gehalten.

In dem erfindungsgemäßen Ausführungsbeispiel ist ein Innenbereich der Vorrichtung zum Drehbelacken atmosphärisch abgeschlossen. Dadurch ergibt sich der Vorteil, dass sich zwischen Substrat und dem Substratsteller eine mitdrehende Luftsäule ausbildet, bzw. der Effekt wird verstärkt. Dadurch wird verhindert, dass Lack oder Beschichtungsmedium auf eine Rückseite des Substrats, die eventuell erst später belackt und/oder beschichtet werden soll, gelangt.

### KURZE BESCHREIBUNG DER FIGUREN

Nachfolgend wird die Erfindung anhand der beiliegenden Zeichnung kurz beschrieben, wobei diese in ihren einzelnen Figuren zeigt:
Figur 1 eine schematische Darstellung einer Seitenansicht eines erfindungsgemässen Substratstellers mit einem Substrat;
Figur 2 eine schematische Darstellung einer Draufsicht eines erfindungsgemässen Substratstellers.

### AUSFÜHRUNGSBEISPIEL

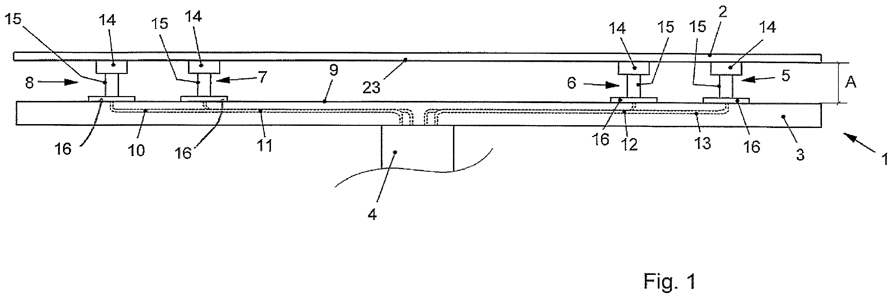

Figur 1 zeigt einen erfindungsgemässen Substratsteller 1 mit einem Substrat 2. Der Substratsteller 1 umfasst eine Platte 3, eine Anschlussstelle 4 und vier Ansaugpunkte 5, 6, 7 und 8.

Im vorliegenden Ausführungsbeispiel sind das Substrat 2 und die Platte 3 jeweils als Kreisscheibe ausgebildet.

In weiteren, nicht dargestellten Ausführungsbeispielen werden Platten mit rechteckiger, quadratischer oder dreieckiger Form verwendet. Grundsätzlich eignen sich alle Plattenformen für alle Substratsformen. Wichtig ist nur die Anordnung der Ansaugpunkte.

Jeder der Ansaugpunkte 5, 6, 7 und 8 weist einen Abstand A von einer Oberfläche 9 der Platte 3 auf. Dadurch ergibt sich der Vorteil, dass das Substrat 2 nur wenige Auflagepunkte mit dem Substratteller 1 ausbildet. Dadurch wird die Anzahl von Kontaktstellen die zu einer Beschädigung der Oberfläche oder der Beschichtung führen könnten, verringert.

Jeder der Ansaugpunkte 5, 6, 7 und 8 ist über einen Kanal 10, 11, 12 und 13 mit einer nicht dargestellten Druckluftquelle verbunden. Die Druckluftquelle ist vorzugsweise an einer Anschlussstelle 4 mit den Kanälen 10, 11,12 und 13 verbunden.

Die Ansaugpunkte 5, 6, 7 und 8 weisen jeweils ein Röhrchen 15 auf. Die Länge des Röhrchens 15 bestimmt den Abstand A des Ansaugpunkts 5, 6, 7, und 8 beziehungsweise des Substrats 2 von einer Oberfläche 9 der Platte 3.

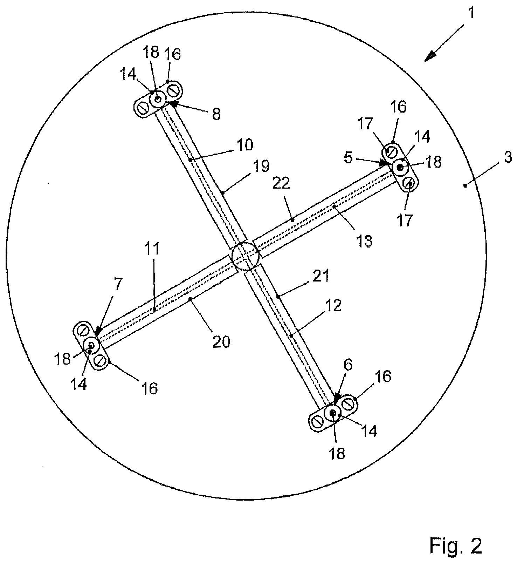

Das Röhrchen 15 umfasst einen Fuss 16. Mit dem Fuss 16 wird das Röhrchen 15 jeweils an der Platte 3 fixiert. Wie in Figur 2 erkennbar, wird der Fuss 16 vorzugsweise auf die Platte 3 mit Schrauben 17 geschraubt.

Jeder der Ansaugpunkte 5, 6, 7 und 8 weist eine flexible Oberfläche auf. Im erfindungsgemäßen Ausführungsbeispiel wird die flexible Oberfläche jeweils durch eine Gummilippe 14 gebildet. Die Gummilippe 14 wird dazu auf eine obere Kante des Röhrchens 15 gestreckt, so dass eine Öffnung 18 frei bleibt.

Vorzugsweise werden die Kanäle 10, 11,12 und 13 von einer Oberfläche 9 der Platte 3 aus in die Platte 3 gefräst. Wie in Figur 2 erkennbar, werden die Kanäle 10, 11, 12 und 13 jeweils durch ein Verschlussstück 19, 20, 21 und 22 verschlossen. Dadurch ergibt sich der Vorteil, dass die Kanäle auf einfache Art und Weise hergestellt werden können.

Die Funktionsweise der Erfindung ist folgende:
Der Substratsteller 1 wird vorzugsweise in Vorrichtungen zum Drehbelacken von Substraten eingesetzt. Dazu wird der Substratteller 1 an einen Unterdruckquelle angeschlossen.

Dann wird das Substrat 2 auf die Ansaugpunkte 5, 6, 7 und 8 gelegt. Durch den angelegten Unterdruck wird das Substrat 2 auch beim Drehen sicher gehalten. Durch die geringe Anzahl und geringe Grösse der Ansaugpunkte 5, 6, 7 und 8, wird verhindert, dass eine eventuell bereits beschichtete Rückseite 23 beschädigt wird. Dies ist besonders vorteilhaft bei einem Substrat 2, das von beiden Seiten beschichtet werden soll.

Durch die Verwendung des erfindungsgemässen Substratstellers 1 in einer Vorrichtung zum Drehbelacken die atmosphärisch abgeschlossen ist, ergibt sich der Vorteil, dass in dem Bereich zwischen dem Substrat 2 und der Platte 3 eine mitdrehende Luftsäule entsteht. Dadurch wird verhindert, dass Lack oder Beschichtungsmaterial in den Bereich zwischen der Platte 3 und dem Substrat 2 eindringt. Dadurch werden Spritzer auf der Rückseite des Substrats 2 vermieden.

Nach dem Belacken und/oder Beschichten einer Oberseite des Substrats 2 wird die Unterdruckquelle abgeschaltet, so dass das Substrat 2 mit einer Handlingeinheit von dem Substratsteller 1 abgenommen werden kann. Dann wird das Substrat 2 gedreht, sodass die in Figur 1 dargestellte Rückseite 23 nach oben weist und auf die Ansaugpunkte 5, 6, 7 und 8 gelegt.

Jetzt wird die Unterdruckquelle wieder angeschaltet, wodurch das Substrat 2 wieder sicher an den Ansaugpunkten 5, 6, 7 und 8 gehalten wird.

Der Substratsteller 1 wird zum Beschichten und/oder Belacken der jetzt oben liegenden Rückseite 23 des Substrats 1 gedreht. Dies ist, wie bereits beschrieben sehr schonend für die jetzt unten liegende bereits beschichtete Oberseite. Zum einen sind wenige Kontaktstellen vorhanden, die die Beschichtung beschädigen könnten. Zum anderen wird durch die mitdrehende Luftsäule verhindert, dass bei dem zweiten Beschichtungs- und/oder Belackungsvorgang Spritzer auf die jetzt unten liegende, bereits beschichtete, zur Platte 3 weisende, Seite des Substrats gelangen können.

### BEZUGSZEICHENLISTE

- 1: Substratsteller
- 2: Substrat
- 3: Platte
- 4: Anschlussstelle
- 5: Ansaugpunkt
- 6: Ansaugpunkt
- 7: Ansaugpunkt
- 8: Ansaugpunkt
- 9: Oberfläche
- 10: Kanal
- 11: Kanal
- 12: Kanal
- 13: Kanal
- 14: Gummilippe
- 15: Röhrchen
- 16: Fuss
- 17: Schraube
- 18: Öffnung
- 19: Verschlussstück
- 20: Verschlussstück
- 21: Verschlussstück
- 22: Verschlussstück
- 23: Rückseite

## Patentansprüche

1. Substratteller (1) zur Aufnahme eines Substrats (2) in einer Vorrichtung zum Drehbelacken des Substrats (2),
- wobei der Substratteller (1) an einer Oberfläche (9) drei Ansaugpunkte (5, 6, 7, 8) aufweist, wobei jeder der Ansaugpunkte (5, 6, 7, 8) einen Abstand (A) von einer Oberfläche (9) einer Platte (3) aufweist, wobei jeder der Ansaugpunkte (5, 6, 7, 8) jeweils ein Röhrchen (15) aufweisen, wobei die Länge des Röhrchens (15) den Abstand (A) des Ansaugpunkts (5, 6, 7, 8) beziehungsweise des Substrats (2) von der Oberfläche (9) der Platte (3) bestimmt,
- wobei der Ansaugpunkt (5, 6, 7, 8) über einen Kanal (10, 11, 12, 13) mit einer Unterdruckquelle verbunden ist, wobei der Kanal (10, 11, 12, 13) in dem Substratteller (1) angeordnet ist, wobei sich über den Abstand (A) zwischen der Oberfläche des Substrattellers (1) und dem aufgenommenen Substrat (2) eine Luftsäule ausbildet, wobei sich der Substratteller (1) und das Substrat (2) drehen, wobei ein Innenbereich der Vorrichtung zum Drehbelacken atmosphärisch abgeschlossen ist, **dadurch gekennzeichnet, dass** der Kanal (10, 11, 12, 13) in eine Oberfläche des Substrattellers (1) eingefräst ist und durch ein Verschlussstück (19, 20, 21, 22) verschlossen ist, wobei der Ansaugpunkt (5, 6, 7, 8) eine flexible Oberfläche umfasst, wobei der Ansaugpunkt (5, 6, 7, 8) einen Abstand von 1 mm bis 30 mm, besonders bevorzugt 7 mm von einer Oberfläche (9) des Substratstellers (1) aufweist, wobei die flexible Oberfläche jeweils durch eine Gummilippe 14 gebildet ist, wobei die Gummilippe 14 dazu auf eine obere Kante des Röhrchens 15 gestreckt ist, so dass eine Öffnung 18 frei bleibt.

2. Substratteller (1) nach Anspruch 1, **dadurch gekennzeichnet, dass** der Substratteller (1) vier Ansaugpunkte (5, 6, 7, 8) umfasst.

## Claims

1. Substrate plate (1) to accommodate a substrate (2) in an apparatus for spin-coating of substrate (2),
- wherein the substrate plate (1) has three suction points (5, 6, 7, 8) on one surface (9), wherein each of the suction points (5, 6, 7, 8) has a distance (A) from a surface (9) of a plate (3), wherein each of said suction points (5, 6, 7, 8) comprises a respective tube (15), the length of the tube (15) determining the distance (A) of the suction point (5, 6, 7, 8) respectively of the substrate (2) from the surface (9) of the plate (3),
- wherein the suction point (5, 6, 7, 8) is connected to a vacuum source via a channel (10, 11, 12, 13), wherein the channel (10, 11, 12, 13) is arranged in the substrate plate (1), wherein an air column is formed over the distance (A) between the surface of the substrate plate (1) and the received substrate (2), wherein the substrate plate (1) and the substrate (2) rotate, wherein an inner region of the apparatus for spin-coating is atmospherically sealed,
**characterized in that**
the channel (10, 11, 12, 13) is milled into a surface of the substrate plate (1) and is closed by a closure piece (19, 20, 21, 22), wherein the suction point (5, 6, 7, 8) has a flexible surface, wherein the suction point (5, 6, 7, 8) has a distance of 1 mm to 30 mm, particularly preferably 7 mm from surface (9) of the substrate plate (1), wherein the flexible surface is surface is formed in each case by a rubber lip (14), wherein the rubber lip (14) is stretched onto an upper edge of the tube (15), so that an opening (18) remains free.

2. Substrate plate (1) according to claim 1, **characterized in that** the substrate plate (1) includes four suction points (5, 6, 7, 8).

## Revendications

1. Plaque de substrat (1) pour la réception d'un substrat (2) dans un dispositif de revêtement rotatif du substrat (2),
- la plaque de substrat (1) présentant trois points d'aspiration (5, 6, 7, 8) sur une surface (9), chacun des points d'aspiration (5, 6, 7, 8) présentant une distance (A) par rapport à une surface (9) d'une plaque (3), chacun des points d'aspiration (5, 6, 7, 8) présentant chacun un tube (15), la longueur du tube (15) définissant la distance (A) du point d'aspiration (5, 6, 7, 8) et du substrat (2) par rapport à la surface (9) de la plaque (3),
- le point d'aspiration (5, 6, 7, 8) étant relié à une source de vide par l'intermédiaire d'un canal (10, 11, 12, 13), le canal (10, 11, 12, 13) étant disposé dans la plaque de substrat (1),
une colonne d'air se formant sur la distance (A) entre la surface de la plaque de substrat (1) et le substrat (2) reçu, la plaque de substrat (1) et le substrat (2) pivotant, une zone intérieure du dispositif de revêtement rotatif étant fermée à la pression atmosphérique, **caractérisée en ce que** le canal (10, 11, 12, 13) est fraisé dans une surface de la plaque de substrat (1) et est fermé par un obturateur (19, 20, 21, 22), le point d'aspiration (5, 6, 7, 8) comprenant une surface souple, le point d'aspiration (5, 6, 7, 8) présentant une distance de 1 à 30 mm, particulièrement de 7 mm à partir d'une surface (9) de la plaque de substrat (1), la surface flexible étant formée par une lèvre en caoutchouc (14), la lèvre en caoutchouc (14) étant étirée sur un bord supérieur du tube (15) de telle sorte qu'une ouverture (18) reste libre.

2. Plaque de substrat (1) selon la revendication 1, **caractérisée en ce que** la plaque de substrat (1) comprend quatre points d'aspiration (5, 6, 7, 8).
